(19) Europäisches Patentamt
European Patent Office
Office européen des brevets

(11) **EP 0 613 765 B1**

(12) **EUROPÄISCHE PATENTSCHRIFT**

(45) Veröffentlichungstag und Bekanntmachung des Hinweises auf die Patenterteilung:
**15.12.1999 Patentblatt 1999/50**

(51) Int. Cl.$^6$: **B28D 5/00**, B24B 9/06, B23Q 1/25

(21) Anmeldenummer: **94102776.5**

(22) Anmeldetag: **24.02.1994**

(54) **Verfahren zum Herstellen von unterteilbaren Platten aus sprödem Material mit hoher Genauigkeit**

Method for the manufacture of subdividable tiles from a brittle material

Méthode pour la fabrication de carreaux subdivisibles en un matériau cassant

(84) Benannte Vertragsstaaten:
**DE DK GB**

(30) Priorität: **02.03.1993 DE 4306296**
**24.12.1993 DE 4344383**

(43) Veröffentlichungstag der Anmeldung:
**07.09.1994 Patentblatt 1994/36**

(73) Patentinhaber:
**CeramTec AG Innovative Ceramic Engineering**
**73207 Plochingen (DE)**

(72) Erfinder:
- **Hügl, Kurt**
  **D-95615 Marktredwitz (DE)**
- **Leneis, Roland**
  **D-95615 Marktredwitz (DE)**

(74) Vertreter:
**Schulz, Wilfried, Dipl.-Ing. et al**
**Dynamit Nobel AG**
**Abt.Patente und Dokumentation**
**53839 Troisdorf (DE)**

(56) Entgegenhaltungen:
**DE-A- 3 404 128**          **US-A- 2 978 804**
**US-A- 3 112 850**          **US-A- 4 629 378**

**Beschreibung**

Die Erfindung betrifft ein Verfahren zur wirtschaftlichen Herstellung von hochwertigen, vorzugsweise mehrfach unterteilten, gelaserten Platten aus sprödem, insbesondere keramischem Material, bei dem eine sehr präzise Lage von geometrischen Figuren, wie z.B. Linien, Ausnehmungen und Sollbruchstellen, relativ zu einer Außenkante der Platte in Kombination mit einer sehr guten Kantenqualität erreicht wird siehe z.B. die US-A-3,112,850).

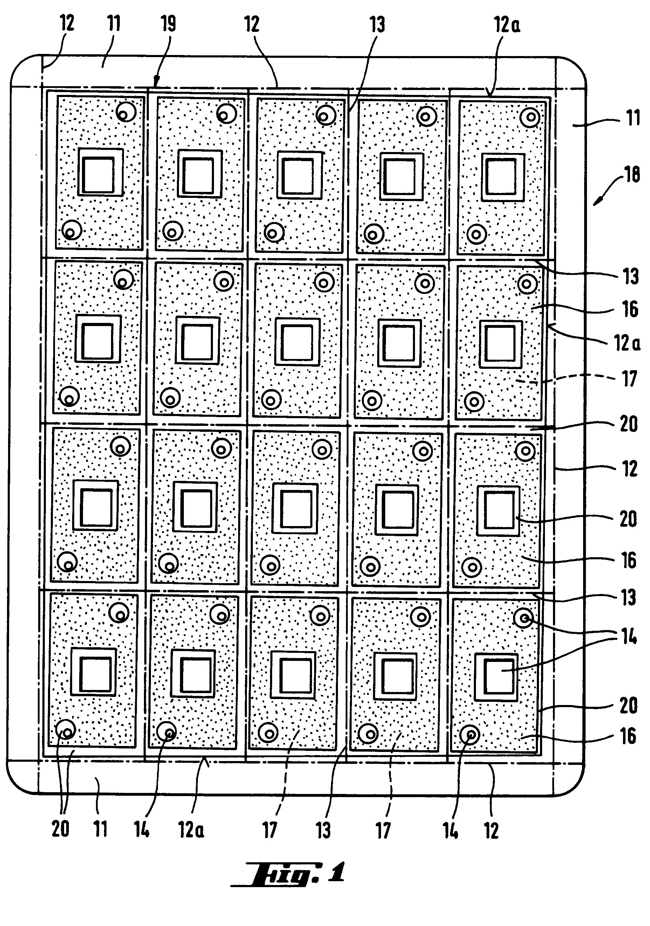

Die Herstellung solcher Platten aus keramischem Material nach dem in der Technik üblichen Verfahren wird anhand von Figur 1 erläutert. Danach wird in eine Keramikplatte (18) in einem ersten Laser-Bearbeitungsschritt eine äußere Sollbruchstelle (12) für eine Außenkontur geritzt und dann der Rand (11) der Platte abgebrochen, so daß die nutzbare Platte (19) stehen bleibt. Danach werden die Stirnflächen möglichst rechtwinklig zueinander sowie rechtwinklig zur Ober- bzw. Unterseite von (19) und gleichzeitig auf Maß geschliffen, um die Kantenqualität zu verbessern. Dadurch entsteht die Schleifkontur (12a). Gegebenenfalls werden noch in einem zweiten Laser-Bearbeitungsschritt innere Sollbruchstellen (13), Bohrungen und/oder kleine rechteckige Ausnehmungen (14) angebracht. Dieses Verfahren ist unter dem Namen "Anschlaglasern" bekannt. Die nutzbare Platte (19) gemäß Figur 1 ist durch Zerbrechen an den Sollbruchstellen (13) in 20 kleinere rechteckige Plättchenabschnitte (17) gleicher Größe zerlegbar.

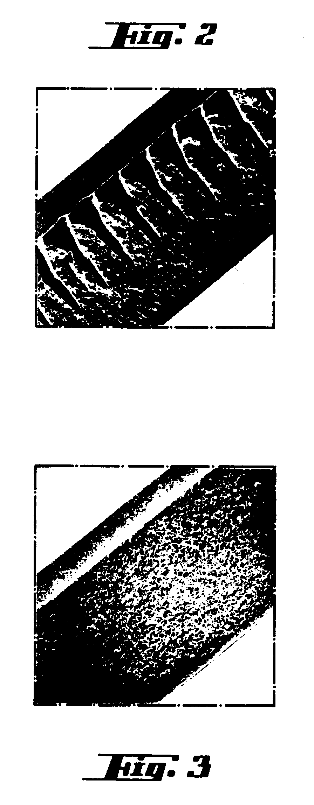

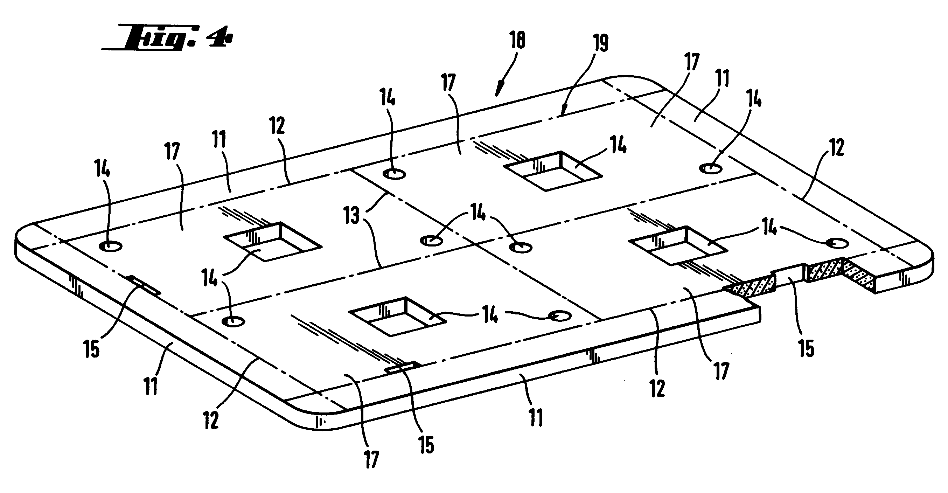

Der Rand (11) dient nur dem automatischen Handling, der Standardisierung der Formate sowie dem Ausgleich der geringfügigen Positionsunschärfe bei der simultanen Laserbehandlung mehrerer Platten auf Mehrkopflaser. Er wird üblicherweise von Hand abgebrochen. Dabei, sowie durch die Laserspur selbst entsteht in der Mikrostruktur eine rauhe, manchmal auch in Längsrichtung wellige, auf jeden Fall aber eine bezüglich ihrer geometrischen Mikrogenauigkeit undefinierte Stirnfläche. Figur 2 zeigt eine solche Stirnfläche. Eine solche Stirnfläche ist sehr stoßempfindlich und kann leicht ausbrechen. Die scharfkantigen Splitter liegen dann auf der Oberfläche der nutzbaren Platte und führen bei einer Hybridherstellung (Herstellung einer gedruckten Schaltung (16) durch Aufdrucken einer Metallpaste) leicht zu Freistellen im Druckbild oder sogar zur Zerstörung des Drucksiebes, was größere Produktionsausfälle nach sich zieht. Diese, für ein genaues und fehlerfreies Weiterverarbeiten hinderliche Stirnflächenform muß nun durch Schleifen verbessert werden, um rechte Winkel in allen drei Raumrichtungen zu erzeugen und Makro- und Mikrowelligkeit sowie Rauhigkeit der Bruchfläche und Ausbrüche zu verringern. Figur 3 zeigt eine Stirnfläche nach dem Schleifen.

Unter "Schleifen" werden alle Verfahren der mechanischen bzw. spanabhebenden Bearbeitung verstanden, einschließlich des alternativ möglichen Flüssigkeitsstrahlschneidens, das auch anstelle des Laser-Durchtrennens verwendet werden kann.

Durch die Verbesserung der Stirnflächen kann bei der Hybridfertigung der Sicherheitsabstand (20) zwischen Druckbild (16) und äußerer Sollbruchstelle (12) verringert und somit bei gleichen Abmessungen der gesamten Platte die verwendbare Fläche von (19) vergrößert werden.

Die solchermaßen hergestellten Platten für die Mikroelektronik haben typischerweise eine Kantenlänge von 5 x 5 cm bis 20 x 20 cm, wobei ein vereinzeltes Bauteil (17) aus einer derartigen Platte nur wenige Quadratmillimeter groß sein kann.

Dieses Verfahren hat den Nachteil, daß die Platten zum Schleifen der Stirnflächen viermal umgespannt werden müssen und daß zum Ausgleich von Maß- und Formabweichungen, die beim Abbrechen der Ränder auftreten, ein Aufmaß von 0,5 mm bis 0,7 mm zum Schleifen nötig ist.

Die nach dem Stand der Technik erhaltenen Platten sind im allgemeinen rechteckig. Mangelnde Sorgfalt beim Abbrechen des äußeren Randes und beim Schleifen kann dabei zu Platten führen, bei denen eine Kante schiefwinklig ist (Trapezform) oder mehrere Kanten schiefwinklig sind (parallelogrammartige Form). Falls dann später die inneren Sollbruchstellen (13) und gegebenenfalls Ausnehmungen (14) eingebracht werden sollen, verschlechtert sich die Genauigkeit der Positionierung. Für diesen Fall muß ein Sicherheitsabstand (20) zwischen Druckbild (16) und äußerer Sollbruchstelle (12) und zwischen (16) und inneren Sollbruchstellen (13) eingehalten werden, der allseitig ca. 0,3 mm beträgt. Bei ungeschliffenen Platten ist sogar ein Sicherheitsabstand von ca. 0,5 mm jeder zu schleifenden Kante und an den Sollbruchstellen zum Druckbild (16) erforderlich. Der Sicherheitsabstand muß so groß sein, daß er Winkelabweichungen und Parallelverschiebungen von Ausnehmungen (14), wie z.B. Bohrungen, und inneren Sollbruchstellen (13) zur Schleifkontur (12a) abfängt.

Außerdem kann nur ein relativ grobes Druckbild einer elektrischen Schaltung gedruckt werden, weil man Sollbruchstellen (13) und Ausnehmungen (14) im Inneren von (19) trotz Schiefwinkligkeit und Lageabweichung mit den Leiterbahnen der gedruckten Schaltung nicht treffen darf, bzw. durchzukontaktierende Ausnehmungen und Durchbrüche (14) treffen muß. Weiterhin muß die Platte wie beschrieben in zwei unterschiedlichen Arbeitsgängen gelasert werden, was den doppelten Arbeits- und Rüstaufwand sowie doppelte Handhabung mit zusätzlichen Fehlermöglichkeiten bedingt.

Beim Lasern kommt es durch Wärmeentwicklung und andere Einflüsse während des Betriebes zu geringfügigen Dejustierungen und Inhomogenitäten, die es aus Qualitätsgründen nicht erlauben, bei Mehrkopflasern, wie sie üblicherweise anstelle von Einkopflasern eingesetzt werden, mehr als einen Arbeitskopf zur Herstellung oben beschriebener Platten simultan einzusetzen.

Dadurch wird die mögliche Arbeitsleistung eines Lasers im günstigsten Fall halbiert (bei 2-Kopf Laser), was eine kostengünstige Herstellung unterteilter Platten bei erhöhten Maßanforderungen ausschließt.

Ziel der vorliegenden Erfindung ist es, ein kostengünstiges Verfahren zu schaffen, das die Herstellung von Platten aus sprödem Material, insbesondere rechteckigen Platten, mit hoher Genauigkeit erlaubt, die auch beliebig gestaltete innere Sollbruchstellen (13), Ausnehmungen (14), wie z.B. Bohrungen, und/oder durch Metallpasten erzeugte Druckbilder (16) aufweisen können.

Es wurde nun ein Verfahren zum Herstellen einer Platte aus einem spröden Material gefunden, die durch Brechen zu einem oder mehreren kleineren Plättchen mit vorbestimmten Abmessungen vereinzelbar ist. Das Verfahren ist dadurch gekennzeichnet, daß man in einer Einzelplatte großer Abmessung aus einem spröden Material durch Laserritzen

a parallele erste Sollbruchstellen jeweils im Abstand $d_a$ sowie
b parallele zweite Sollbruchstellen jeweils im Abstand $d_b$ erzeugt,

die die ersten Sollbruchstellen schneiden, wobei a und b ganze Zahlen über 1 sind, man im Außenbereich im Abstand $d_a$ zu den beiden äußeren ersten Sollbruchstellen und im Abstand $d_b$ zu den beiden äußeren zweiten Sollbruchstellen die Randzone entfernt, so daß die verbleibende Platte, ohne Randstücke, $(a-1) \cdot (b-1)$ Plättchenabschnitte gleicher Größe enthält, die durch jeweils vier Sollbruchstellen begrenzt werden. Alle Sollbruchstellen sollen die verbleibende Platte durchmessen, d.h. nicht in ihr enden. Daher enthält die verbleibende Platte in ihrer Randzone $2 \cdot (a + b)$ Plättchenabschitte, die nur 2 oder 3 Sollbruchstellen aufweisen.

Vorzugsweise wird als sprödes Material der relativ großen Einzelplatte Keramik verwendet. Das Entfernen der Randzone kann durch Laser-Ritzen und Abbrechen, Laser-Schneiden oder mechanisches Schneiden (Sägen, Wasserstrahlschneiden oder ähnliche Trennverfahren) erfolgen. Falls die Randzone durch Laser-Ritzen und Abbrechen entfernt wird, so sollen die Stirnflächen der nutzbaren Platte anschließend geschliffen werden.

Das allseitige Schleifen der Außenkontur (12) nach Abbrechen des Randes ist notwendig, um später bei der Herstellung von Hybridschaltungen das Druckbild (16) des Siebdrucks exakt und mit hoher Winkelgenauigkeit zu (13) und (14) auf der nutzbaren Platte (19) positionieren zu können und Kantenabsplitterungen beim Positionieren der Platte zum Siebdruck weitgehend zu vermeiden.

Vorzugsweise geht man von einer etwa rechteckigen relativ großen Platte aus und ordnet die ersten und die zweiten Sollbruchstellen so an, daß sie senkrecht zueinander verlaufen, so daß die (nach Entfernen der Randzone) verbleibende Platte rechteckig ist und gegebenenfalls in mehrere rechteckige Plättchenabschnitte gleicher Größe vereinzelbar ist.

Es gelingt mit dem erfindungsgemäßen Verfahren die Parallelitätsabweichungen gegenüberliegender Stirnflächen der durch Trennen und Schleifen hergestellten Nutzflächen ohne weiteres auf maximal 0,05 %, vorzugsweise auf maximal 0,03 % der Nutzflächen-Kantenlänge zu begrenzen.

Das erfindungsgemäße Verfahren ist besonders wertvoll, wenn man in den kleinen Plättchenabschnitten an präzise vorherbestimmter Position durch Laserbohren mindestens ein Loch, durch Laserschneiden mindestens eine Ausnehmung und/oder durch Siebdruck eine gedruckte elektrische Schaltung erzeugen will.

Falls das Entfernen der Randzone durch Laser-Schneiden ("Methode 1") oder duch mechanisches Absägen erfolgt, kann der Schleifprozeß eingespart werden, da die erzeugten Kanten glatt und beschädigungsfrei sind. Gleichzeitig mit dem Erzeugen der Außenkontur (12) und in derselben Aufspannung können mit einem Mehrkopf-Laser die Ausnehmungen (14) und die inneren Sollbruchstellen (13) erzeugt werden.

Bei einer anderen Ausgestaltung des erfindungsgemäßen Verfahrens geht man so vor, daß man die Platte zur Entfernung der Randzone laserritzt, man bei diesem äußeren Laserritzen einen Abstand einhält, der geringfügig größer ist (ca 0,1 bis 0,2 mm) als der Abstand $d_a$ bzw. $d_b$, man die durch Laserritzen erzeugte Randzone abbricht und man die beim Abbrechen entstandenen Bruchkanten der Platte abschleift, bis der Abstand zur nächsten Sollbruchstelle exakt $d_a$ bzw. $d_b$ beträgt ("Methode 2").

Im allgemeinen wird eine Platte oder werden nebeneinander mehrere Platten auf einem Lasertisch frei, aber geordnet positioniert. Dann werden von einem oder mehreren Laserköpfen in einem Zuge die äußeren Sollbruchstellen (12) im Inneren der Platte (18) und gegebenenfalls innere Sollbruchstellen (13) sowie Ausnehmungen und Bohrungen (14) gelasert. Nach dem Abbrechen des Randes (11) erfolgt das präzise Schneiden oder Schleifen der Stirnflächen. Dabei muß jede einzelne Platte für den Schleifvorgang mit elektronischen Mitteln z.B. Fotodioden oder Kamera und x-y-Positioniertisch anhand der Innenkonturen (13) oder der Ausnehmungen (14) ausgerichtet werden.

Da die Platte anhand der Konturen von (12), (13) und (14) zum Schleifen positioniert wird, ist gewährleistet, daß sowohl Winkigkeit wie Form- und Lagetoleranz der äußeren Sollbruchstelle (12) und Innenkonturen von (13) und (14) zueinander auf jeder Platte sehr nahe an der Arbeitsgenaugkeit der elektronischen Meßvorrichtung liegen.

Auch wenn sich, wie es bei Mehrkopflasern vorkommt, die verschiedenen Laserköpfe im Betrieb unterschiedlich verhalten, ist durch die elektronische Ausrichtung im zweiten Arbeitsgang dennoch die maximale Genauigkeit in der Platte und von Platte zu Platte gegeben.

Um zu vermeiden, daß die innere Sollbruchstelle (13) und Ausnehmungen (14) auf der Nutzfläche zu den Außenkanten parallel verschoben und/oder verdreht liegen, werden nach einer anderen bevorzugten Ausgestaltung des erfindungsgemäßen Verfahrens an den durch Laserritzen erzeugten äußeren Sollbruchstellen durch Laserschneiden mindestens drei schmale, rechteckige Ausnehmungen angebracht, von denen mindestens zwei auf der gleichen Seite und mindestens eine auf einer benachbarten Seite angeordnet sind. An der Stelle der Ausnehmungen kann selbstverständlich auf das vorhergehende Ritzen verzichtet werden. Vorzugsweise berühren die schmalen Ausnehmungen die äußeren, durch Laserritzen erzeugten Sollbruchstellen von außen oder stimmen die Mittelachsen der Ausnehmungen mit den Sollbruchstellen überein.

Im allgemeinen wird mit einem Mehrkopf-Laser gleichzeitig die äußere Sollbruchstelle (12) der Platte durch Laser-Ritzen und Laser-Schneiden von drei Anschlagflächen (15) an zwei benachbarten Kanten zusammen mit Sollbruchstellen (13) und Innenkonturen von (14) hergestellt.

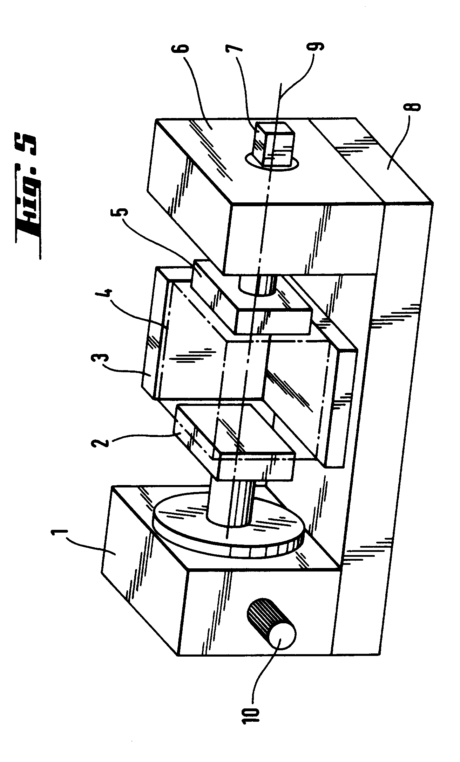

Fig. 4 zeigt ein Rohsubstrat (18) mit lasergeritzter äußerer Sollbruchstelle (12), Brechrand (11), lasergeritzten inneren Sollbruchstellen (13), lasergeschnittenen Ausnehmungen (14) und drei lasergeschnittenen Kantenabschnitten (15). Die Abschnitte (15) sind wohldefiniert und glatt und dienen beim Schleifen als Anschlagpunkte.

Man kann eine einzige nach diesem Verfahren präparierte Platte exakt und reproduzierbar in eine drehbare Schleifvorrichtung einspannen, die Platte drehen und alle vier Stirnseiten exakt auf Maß und Winkeligkeit schleifen, ohne die Aufspannung zu lösen.

Das Verfahren ist jedoch wirtschaftlich besonders interessant, wenn man eine Vielzahl von rechteckigen Platten, deren durch Laserritzen erzeugte Randzone abgebrochen wurde, so übereinanderstapelt, daß die Konturen entsprechender schmaler Ausnehmungen übereinander liegen, man den Stapel zusammenpreßt und man entsprechende Außenkonturen der rechteckigen Platten gleichzeitig durch Schleifen begradigt ("Methode 3").

Eine erfindungsgemäße Vorrichtung zum Aufnehmen und präzisen Schleifen von rechteckigen Platten, die für das Verfahren gut geeignet ist, wird nachstehend unter Zuhilfenahme von Figur 5 näher beschrieben.

Es stellen dar:

Position 1    eine Präzisionsteileinrichtung mit in einer Ebene senkrecht zur Achse (9) stehenden und um diese Achse drehbaren Spannbacke (2), die mittels der Schraube (10) in einem vorbestimmten Drehwinkel arretierbar ist.

Position 3    eine Einlegevorrichtung mit zwei senkrecht zueinander stehenden Aufnahmeflächen zum lage- und winkelgenauen Einlegen mindestens einer Platte, bei der der Rand (11) entfernt wurde. Diese Einlegevorrichtung liegt lose auf der Grundplatte (8).

Position 4    Raum für mindestens eine Platte, die zu schleifen ist.

Position 5    eine in Richtung der Achse (9) bewegbare und um diese drehbare Spannbacke, die im Widerlager (6) drehbar gelagert und mittels einer Spindel (7) in Achsrichtung bewegbar ist.

Position 8    Die Grundplatte der Vorrichtung, die mittels Spannpratzen oder Magnetspanntisch auf einem Tisch fest arretierbar ist.

Nicht gezeichnet ist ein Schleifaggregat für das Abschleifen der Kanten (Stirnseiten) des Plattenstapels oder der Platte. Diese Stirnseiten sollen möglichst senkrecht zur Plattenoberfläche verlaufen.

Die Spannbacken (2) und (5) stellen Druckkontakte dar, die eine einzelne Platte festhalten oder mehrere Platten an ihren Flächen als Stapel zusammenpressen. Vorzugsweise verläuft die Rotationsachse durch die Mittelpunkte der Rechtecke der Platten, weil dann im Betrieb der Aufwand zum Verstellen des Abstandes der Schleifvorrichtung am geringsten ist.

Entweder das Schleifaggregat oder die Klammervorrichtung (1, 2, 5) mit den beiden Spannbacken, die den Plattenstapel halten, ist vorzugsweise linear beweglich angeordnet, damit die wirksame Oberfläche der Schleifvorrichtung längs der Stirnseiten des Plattenstapels schleifend vorbeigleiten kann. Die wirksame Schleiffläche soll eine Bewegung in einer Ebene ausführen können, die parallel zur Drehachse der Spannbacken (= Druckkontakte 2, 5) verläuft.

Mit Hilfe der Spannbacken (2 und 5) und der Einlegevorrichtung (3) werden komplett gelaserte und auf Rohmaß gebrochene Platten im Raum (4) angeordnet und zum Schleifen zwischen die um die horizontale Achse (9) drehbaren Spannbacken (2) und (5) eingespannt.

Die Hilfsvorrichtung (3) enthält vorzugsweise Anschlagstellen, insbesondere aus Hartstoffen. Dies ist sinnvoll, wenn die zu schleifenden Platten bereits drei durchgeschnittene Kantenabschnitte (15) aufweisen. Diese Ausgestaltung ermöglicht die exakte, zum Maschinentisch parallele Ausrichtung der nutzbaren Platte.

Nach dem Einspannen wird die Einlegevorrichtung (3) entfernt und die erste Stirnfläche einer Platte wird geschliffen. Nach Fertigstellung dieser Stirnfläche wird die Platte bzw. das Plattenpaket mit Hilfe der Präzisionsteileeinrichtung (1) und dem Widerlager (6) im eingespannten Zustand um 90° geschwenkt und in dieser Stellung zum Schleifen der zweiten Stirnfläche arretiert. Dementsprechend wird auch mit den restlichen Stirnflächen verfahren.

Bei Verwendung der glatten Kantenabschnitte (15) als Anlageflächen liegt die Platte so genau und winkelig in der Vorrichtung, daß es möglich ist, mit minimaler Schleifzugabe von nur 0,1 - 0,2 mm und somit kostengünstig zu arbeiten. Alle Nachteile einer minderwertigen Stirnfläche werden vermieden.

Die Vorrichtung erlaubt es, nicht nur eine einzelne Platte, sondern auch mehrere Platten gleichzeitig einzuspannen und zu schleifen.

Bei der ersten oben dargestellten Methode können mittels (Mehrkopf-)Laser die Außen- und Innenkonturen in einer Aufspannung mit höchster Präzision durch Laser-Ritzen oder/und Laserschneiden hergestellt und somit die Nachteile des Standes der Technik vermieden werden. Außerdem kann der Schleifprozeß gespart werden. Allerdings nimmt man beim Laserschneiden der Außenkanten stark erhöhte Bearbeitungszeiten in Kauf, was Kosten verursacht, da das Laserschneiden ca. 10mal so lange dauert wie das Laser-Ritzen. Zusätzlich muß man damit rechnen, daß beim Laserschneiden punktuell viel Energie in die Platte eingebracht wird und daß durch Thermospannungen Mikrorisse entstehen, die die Festigkeit der Platte beeinträchtigen.

Die zweite Methode erlaubt es ebenfalls, die Platten kostengünstig und in einer Aufspannung auf Mehrkopflaser zu bearbeiten. Beim Schleifen der Stirnflächen jedoch muß jede Platte einzeln aufgelegt, vermessen, ausgerichtet und dann geschliffen werden.

Dabei ist ein hoher Aufwand an Meß- und Regelelektronik und Mechanik notwendig. Außerdem wird die theoretische Leistung der Schleifmaschine durch den zeitraubenden Positioniervorgang und die Einzelbearbeitung stark eingeschränkt.

Die dritte Methode vereinigt alle vorgenannten Vorteile und erlaubt die Vermeidung von Nachteilen. Die Platten können in einer Aufspannung unter Ausnutzung der vollen Laserkapazität bei Mehrkopflasern gelasert werden. Das zeitraubende und kostenintensive Durchschneiden der Außenkontur beschränkt sich auf drei kleine glatte Kantenabschnitte, also nur auf einen Bruchteil des Umfangs.

Mit Hilfe dieser drei Anlagepunkte können unter Einhaltung engster Toleranzen mehrere Platten gleichzeitig in die Schleifvorrichtung eingespannt und bearbeitet werden.

Somit ist es möglich, mit sehr kleiner Schleifzugabe zu arbeiten, womit die Schleifkosten erheblich reduziert werden können.

Die abgehandelten Verfahren wurden verwendet, um jeweils aus keramischen Platten (96 % $Al_2O_3$, Dicke 0,63 mm) 100 Abschnitte zu 10 x 10 cm zu gewinnen. Die Genauigkeiten der erhaltenen Abschnitte werden beobachtet und in den folgenden Tabellen verglichen.

| Parallelität Innen- zu Außenkontur (Werte in %): | | | | |
|---|---|---|---|---|
| Methode | 1 | 2 | 3 | Stand der Technik |
| Mittelwert | 0,027 | 0,041 | 0,027 | 0,066 |
| Streuung | 0,0203 | 0,0262 | 0,0185 | 0,0443 |
| Mindestwert | 0,002 | 0,000 | 0,001 | 0,011 |
| Maximalwert | 0,075 | 0,074 | 0,067 | 0,168 |

| Winkelabweichung (Werte in %): | | | | |
|---|---|---|---|---|
| Methode | 1 | 2 | 3 | Stand der Technik |
| Mittelwert | 0,012 | 0,011 | 0,008 | 0,06 |
| Streuung | 0,0080 | 0,0071 | 0,0067 | 0,027 |
| Maximalwert | 0,02 | 0,02 | 0,02 | 0,12 |

Das erfindungsgemäße Verfahren kann zur Veredelung von Substraten aller Art, sei es Metall, Kunststoff oder Keramik sowie für Verbundwerkstoffe, wie z.B. Leiterplatten oder metallisierte Keramik, und keramischen Laminaten (Multilayer und Monolithe geringer Höhe z.B. Chip-Gehäuse, Piezo-Elemente, Sensoren und Wärmetauscher) eingesetzt werden. Unter Platten werden hier sowohl Platten im engen Sinn für die Mikroelektronik, als auch als Unterlage für andere Einsatzzwecke im allgemeinen Sinn und auch Laminate geringer Höhe verstanden.

**Patentansprüche**

1.  Verfahren zum Herstellen einer Platte aus einem spröden Material, die durch Brechen zu einem oder mehreren kleineren Plättchen vereinzelbar ist, dadurch gekennzeichnet, daß man in einer Einzelplatte großer Abmessung durch Laser-Ritzen

    a parallele erste Sollbruchstellen jeweils im Abstand $d_a$, sowie
    b parallele zweite Sollbruchstellen jeweils im Abstand $d_b$ erzeugt,

    die die ersten Sollbruchstellen schneiden, wobei a und b ganze Zahlen über 1 sind, man im Außenbereich im Abstand $d_a$ zu den beiden äußeren ersten Sollbruchstellen und im Abstand $d_b$ zu den beiden äußeren zweiten Sollbruchstellen die Randzone entfernt, so daß die verbleibende Platte, ohne Randstücke, (a-1) x (b-1) Plättchenabschnitte gleicher Größe enthält, die durch jeweils vier Sollbruchstellen begrenzt werden.

2.  Verfahren nach Anspruch 1, dadurch gekennzeichnet, daß man eine rechteckige Platte einsetzt und man die ersten und die zweiten Sollbruchstellen so anordnet, daß sie senkrecht zueinander verlaufen, so daß die verbleibende Platte rechteckig ist und in rechteckige Plättchenabschnitte gleicher Größe vereinzelbar ist.

3.  Verfahren nach Anspruch 2, dadurch gekennzeichnet, daß man als Material der rechteckigen Einzelplatte Keramik verwendet.

4.  Verfahren nach Anspruch 1, dadurch gekennzeichnet, daß man in den Plättchenabschnitten der verbleibenden Platte durch Laserbohren mindestens ein Loch erzeugt.

5.  Verfahren nach Anspruch 2, dadurch gekennzeichnet, daß man in den rechteckigen Plättchenabschnitten der verbleibenden Platte durch Laserschneiden eine Ausnehmung erzeugt.

6.  Verfahren nach Anspruch 1, dadurch gekennzeichnet, daß man die Randzone mittels Laser abschneidet.

7.  Verfahren zum Herstellen einer Platte aus einem spröden Material, die durch Brechen zu einem oder mehreren kleineren Plättchen vereinzelbar ist, dadurch gekennzeichnet, daß man in einer Einzelplatte großer Abmessung durch Laser-Ritzen

    a parallele erste Sollbruchstellen, außer im Randbereich jeweils im Abstand $d_a$, sowie
    b parallele zweite Sollbruchstellen, außer im Randbereich jeweils im Abstand $d_b$ erzeugt,

    die die ersten Sollbruchstellen schneiden, wobei a und b ganze Zahlen über 1 sind und wobei man die Platte zur Entfernung der Randzone so laserritzt, daß man bei diesem äußeren Laserritzen einen Abstand einhält, der geringfügig größer ist als der Abstand $d_a$ bzw. $d_b$, man die durch Laserritzen erzeugte Randzone abbricht und man die beim Abbrechen entstandenen Bruchkanten der Platte abschleift, bis der Abstand zur nächsten Sollbruchstelle exakt $d_a$ bzw. $d_b$ beträgt.

8.  Verfahren nach Anspruch 7, dadurch gekennzeichnet, daß man an den durch Laserritzen erzeugten äußeren Sollbruchstellen durch Laserschneiden mindestens drei schmale Ausnehmungen anbringt, von denen mindestens zwei auf der gleichen Seite und mindestens eine auf einer benachbarten Seite angeordnet sind.

9.  Verfahren nach Anspruch 8, dadurch gekennzeichnet, daß die schmalen Ausnehmungen die äußeren, durch Laserritzen erzeugten Sollbruchstellen von außen berühren.

10. Verfahren gemäß Anspruch 8, dadurch gekennzeichnet, daß die Mittelachsen der schmalen Ausnehmungen die gleiche Position besitzen, wie die durch Laserritzen erzeugten äußeren Sollbruchstellen.

11. Verfahren nach Anspruch 1 oder 7, dadurch gekennzeichnet, daß man eine Vielzahl von rechteckigen Platten, deren durch Laserritzen erzeugte Randzone abgebrochen wurde, so übereinanderstapelt, daß die Konturen entsprechender schmaler Ausnehmungen übereinander liegen, man den Stapel zusammenpreßt und man entsprechende Außenkonturen der rechteckigen Platten gleichzeitig durch Schleifen begradigt.

**12.** Verfahren nach Anspruch 1, dadurch gekennzeichnet, daß man die Randzone absägt, man beim Absägen einen Abstand zu den nächsten Sollbruchstellen einhält, der dem Abstand $d_a$ bzw. $d_b$ entspricht.

**13.** Verfahren nach Anspruch 1, dadurch gekennzeichnet, daß man die nach Entfernen der Randzonen verbleibende Platte mindestens teilweise mit Metallpaste bedruckt und diese einbrennt.

**Claims**

**1.** Method for producing a plate from a brittle material, which plate can be divided up by means of breaking to form one or more smaller plates, characterized in that

a parallel first predetermined breaking positions each with a clearance $d_a$, and
b parallel second predetermined breaking positions each with a clearance $d_b$,

are produced in a large size single plate by means of laser notching, with the second predetermined breaking positions intersecting the first predetermined breaking positions, with a and b being whole numbers above 1, the edge zone is removed in the outer region with spacing $d_a$ from the two outer first predetermined breaking positions and with clearance $d_b$ from the two outer second predetermined breaking positions, with the result that the remaining plate, without edge pieces, contains (a-1) x (b-1) small plate sections of the same size, which are limited by four respective predetermined breaking positions.

**2.** Method according to claim 1, characterized in that a rectangular plate is used and the first and the second predetermined breaking positions are arranged in such a way that they extend at right angles to each other, so that the remaining plate is rectangular and can be divided up into rectangular small plate sections of the same size.

**3.** Method according to claim 2, characterized in that ceramic material is used as the material of the rectangular single plate.

**4.** Method according to claim 1, characterized in that at least one hole is produced in the small plate sections of the remaining plate by means of laser drilling.

**5.** Method according to claim 2, characterized in that a recess is produced in the rectangular small plate sections of the remaining plate by means of laser cutting.

**6.** Method according to claim 1, characterized in that the edge zone is cut off by means of a laser.

**7.** Method for producing a plate from a brittle material, which plate can be divided up by means of breaking to form one or more smaller plates, characterized in that

a parallel first predetermined breaking positions each with a clearance $d_a$ apart from in the edge region, and
b parallel second predetermined breaking positions each with a clearance $d_b$ apart from in the edge region,

are produced by means of laser notching in a large size single plate with the second predetermined breaking positions intersecting the first predetermined breaking positions, with a and b being whole numbers above 1, and with the plate being laser-notched to remove the edge zone in such a way that with this outer laser notching a spacing is maintained which is slightly larger than the spacing $d_a$ or $d_b$, the edge zone produced by means of laser notching is broken off and the broken edges of the plate, produced upon the breaking-off, are ground until the spacing from the next predetermined breaking position amounts to exactly $d_a$ or $d_b$.

**8.** Method according to claim 7, characterized in that at least three narrow recesses are formed by means of laser cutting at the outer predetermined breaking positions produced by means of laser notching, at least two of the recesses being arranged on the same side and at least one being arranged on an adjacent side.

**9.** Method according to claim 8, characterized in that the narrow recesses contact the outer predetermined breaking positions from the outside, with the predetermined breaking positions being produced by means of laser notching.

**10.** Method according to claim 8, characterized in that the central axes of the narrow recesses have the same position as the outer predetermined breaking positions produced by means of laser notching.

**11.** Method according to claim 1 or 7, characterized in that a plurality of rectangular plates, the edge zone of which produced by means of laser notching has been broken off, are stacked on top of each other in such a way that the contours of corresponding narrow recesses lie on top of each other, the stack is compressed and corresponding outer contours of the rectangular plates are simultaneously levelled by means of grinding.

**12.** Method according to claim 1, characterized in that the edge zone is sawn off, with the sawing-off a clearance from the next predetermined breaking positions, which corresponds to the clearance $d_a$ or $d_b$, being maintained.

**13.** Method according to claim 1, characterized in that the plate remaining after the removal of the edge zones is printed at least partially with metal paste and baked.

**Revendications**

**1.** Procédé de fabrication d'une plaque en un matériau cassant pouvant être découpée par rupture en une ou plusieurs plaquettes de plus petites dimensions, caractérisé par le fait qu'on réalise par gravure laser dans une plaque élémentaire de grandes dimensions

a des premières lignes de rupture parallèles, à une distance $d_a$ chaque fois et
b des secondes lignes de rupture parallèles, à une distance $d_b$ chaque fois, qui sont sécantes avec les premières lignes de rupture,

a et b étant des nombres entiers supérieurs à 1,
que dans la zone extérieure, à une distance $d_a$ des deux premières lignes de rupture extérieures et à une distance $d_b$ des deux secondes lignes de rupture extérieures, on élimine la zone de bord, de telle sorte que la plaque restante, sans les parties de bord, contienne (a-1) * (b-1) plaquettes découpées de mêmes dimensions, qui sont délimitées chacune par quatre lignes de rupture.

**2.** Procédé selon la revendication 1, caractérisé par le fait qu'on utilise une plaque rectangulaire et qu'on dispose les premières et les secondes lignes de rupture de telle sorte qu'elles forment un angle droit entre elles, afin que la plaque restante soit rectangulaire et puisse être découpée en plaquettes découpées rectangulaires.

**3.** Procédé selon la revendication 2, caractérisé par le fait qu'on utilise de la céramique comme matériau pour la plaque élémentaire rectangulaire.

**4.** Procédé selon la revendication 1, caractérisé par le fait qu'on réalise au moins un trou par perçage laser dans les plaquettes découpées de la plaque restante.

**5.** Procédé selon la revendication 2, caractérisé par le fait qu'on réalise un évidement par découpage laser dans les plaquettes découpées rectangulaires de la plaque restante.

**6.** Procédé selon la revendication 1, caractérisé par le fait qu'on tronçonne la zone de bord par laser.

**7.** Procédé de fabrication d'une plaque en un matériau cassant pouvant être découpée par rupture en une ou plusieurs plaquettes de plus petites dimensions, caractérisé par le fait qu'on réalise par gravure laser dans une plaque élémentaire de grandes dimensions

a des premières lignes de rupture parallèles, sauf dans la zone de bord à une distance $d_a$ chaque fois et
b des secondes lignes de rupture parallèles, sauf dans la zone de bord à une distance $d_b$ chaque fois,

qui sont sécantes avec les premières lignes de rupture,
a et b et b étant des nombres entiers supérieurs à 1, et la plaque, aux fins d'éliminer la zone de bord, étant gravée par laser en respectant, lors de cette opération, une distance qui est légèrement supérieure à la distance $d_a$ ou $d_b$, la zone de bord produite par gravure laser étant séparée par rupture et les bords de rupture de la plaque ainsi formés étant meulés jusqu'à ce que la distance jusqu'à la ligne de rupture suivante soit exactement $d_a$ ou $d_b$.

**8.** Procédé selon la revendication 7, caractérisé par le fait qu'on réalise par découpage laser, au niveau des lignes de rupture extérieures obtenues par gravure laser, au moins trois évidements étroits, parmi lesquels deux au moins sont disposés sur le même côté et un au moins est disposé sur un côté voisin.

**9.** Procédé selon la revendication 8, caractérisé par le fait que les évidements étroits touchent extérieurement les lignes de rupture extérieures produites par gravure laser.

**10.** Procédé selon la revendication 8, caractérisé par le fait que les axes médians des évidements étroits ont la même position que les lignes de rupture extérieures produites par gravure laser.

**11.** Procédé selon la revendication 1 ou 7, caractérisé par le fait qu'on empile l'une sur l'autre plusieurs plaques rectangulaires dont la zone de bord tracée par gravure laser a été éliminée, de telle sorte que les contours des évidements étroits concernés soient situés les uns au dessus des autres, qu'on applique une pression sur la pile et qu'on rectifie par meulage simultanément les contours extérieurs des plaquettes découpées rectangulaires.

**12.** Procédé selon la revendication 1, caractérisé par le fait qu'on élimine par sciage la zone de bord et qu'on respecte, lors du sciage, une distance par rapport à la ligne de rupture suivante qui correspond à la distance $d_a$ ou $d_b$.

**13.** Procédé selon la revendication 1, caractérisé par le fait qu'on applique au moins partiellement une pâte métallique sur la plaque restant après élimination des zones de bord et on la soumet à une cuisson.

**Fig. 1**

Fig. 2

Fig. 3

Fig. 4

EP 0 613 765 B1

Fig. 5